Europäisches Patentamt

European Patent Office

Office européen des brevets

(19)

(11) **EP 0 743 736 B1**

(12) **EUROPÄISCHE PATENTSCHRIFT**

(45) Veröffentlichungstag und Bekanntmachung des Hinweises auf die Patenterteilung:
**03.03.1999 Patentblatt 1999/09**

(51) Int Cl.$^6$: **H02H 7/18**, H02J 7/00

(21) Anmeldenummer: **96106248.6**

(22) Anmeldetag: **20.04.1996**

(54) **Verfahren zur Überwachung des Ladezustands einer wiederaufladbaren Batterie**

Process for monitoring the capacity of a rechargeable battery

Procédé pour contrôler la capacité d'une batterie rechargeable

(84) Benannte Vertragsstaaten:
**DE FR GB SE**

(30) Priorität: **13.05.1995 DE 19517709**

(43) Veröffentlichungstag der Anmeldung:
**20.11.1996 Patentblatt 1996/47**

(73) Patentinhaber: **ROBERT BOSCH GMBH**
**70442 Stuttgart (DE)**

(72) Erfinder:
• **Fiebig, Arnim**
 **70771 Leinfelden-Echterdingen (DE)**
• **Wolf, Peter, Dipl.-Ing. (FH)**
 **70771 Leinfelden-Echterdingen (DE)**

(56) Entgegenhaltungen:
**US-A- 5 343 137**

**Beschreibung**

Stand der Technik

Die Erfindung geht aus von einem Verfahren zur Überwachung des Ladezustands einer wiederaufladbaren Batterie (eines Akkus), die über einen Schalter mit einem Motor eines Akkuwerkzeugs nach der Gattung des Hauptanspruchs verbunden ist. Es ist schon bekannt, insbesondere bei batteriebetriebenen Elektrowerkzeugen die Batteriespannung zu überwachen und anzuzeigen. Während des Betriebes des Elektrowerkzeuges entlädt sich die Batterie. Die noch verfügbare Arbeitsdauer hängt somit von dem Ladezustand bzw. der Restkapazität der Batterie ab. Diese kann jedoch nicht ohne weiteres angezeigt werden, da die Restkapazität einerseits nicht direkt meßbar ist und andererseits von verschiedenen physikalischen Parametern abhängt. Ein Verfahren zur Überwachung des Ladezustandes einer wiederaufladbaren Batterie ist aus US 5 343 137 bekannt. Bei diesem Verfahren werden die Spannung, der Strom und die Temperatur der Batterie überwacht.

Vorteile der Erfindung

Das erfindungsgemäße Verfahren zur Überwachung des Ladezustands einer wiederaufladbaren Batterie hat demgegenüber den Vorteil, daß allein aus Spannungsmessungen vor, zu Beginn, während und am Ende des Arbeitsvorganges auf die Restkapazität der wiederaufladbaren Batterie geschlossen werden kann. Da die induzierte Spannung der Drehzahl des Ankers proportional ist, läßt sich somit die Drehzahl des Motors während des Arbeitsvorganges überwachen. Unterschreitet diese einen vorgegebenen Wert infolge zu geringer Kapazität bzw. Restladung des Akkus, dann kann der Akku-Werkzeug bzw. die Batterie für den nächsten Arbeitsworgang gesperrt werden, so daß dadurch Schäden an der wiederaufladbaren Batterie und am Akku-Werkzeug vermieden werden.

Durch die in den abhängigen Ansprüchen aufgeführten Maßnahmen sind vorteilhafte Weiterbildungen und Verbesserungen des im Hauptanspruch angegebenen Verfahrens möglich. Besonders vorteilhaft ist, daß für eine vereinfachte Bestimmung der induzierten Spannungen nur zwei Spannungsmessungen erforderlich sind, die zu Beginn und während des Arbeitsvorgangs durchgeführt werden. Die Differenz der beiden Spannungen ist dann ein Maß für die induzierte Spannung am Anker des Motors und somit auch ein Maß für die Drehzahl des Ankers.

Für eine genauere Bestimmung der induzierten Spannung wird nach dem Abschalten des Arbeitsvorganges eine weitere Messung durchgeführt, so daß sich auch unter Berücksichtigung dieser Messung nach einem vorgegebenen Algorithmus die induzierte Spannung ohne weitere Parameter berechnen läßt.

Die induzierte Spannung kann während des Arbeitsvorgangs zu jedem Zeitpunkt bestimmt werden. Da die induzierte Spannung der Drehzahl des Ankers proportional ist, kann daraus auch die Drehzahl bestimmt werden.

Besonders vorteilhaft ist, die induzierte Spannung, wenn der Motor sein maximales Drehmoment abgibt, beispielsweise am Ende eines Schraubvorganges bei einem Akkuschrauber, zu bestimmen, weil diese Spannung dann ein Maß für die Restkapazität der wiederaufladbaren Batterie ist. Ist diese Spannung groß, dann ist die Restkapazität ebenfalls groß. Im umgekehrten Fall kann bei Unterschreiten eines vorgegebenen Grenzwertes die Batterie bzw. das Akku-Werkzeug abgeschaltet werden. Dieser Schaltzustand kann auf einer Anzeige ausgegeben werden, so daß der Bediener des Akku-Werkzeugs über den Ladezustand der Batterie informiert ist und rechtzeitig die Batterie aufladen oder auswechseln kann.

Zeichnung

Ein Ausführungsbeispiel der Erfindung ist in der Zeichnung dargestellt und in der nachfolgenden Beschreibung näher erläutert. Es zeigen Figur 1 ein Blockschaltbild, Figur 2 zeigt einen Stromlaufplan und Figur 3a bis d zeigen Strom- und Spannungsdiagramme.

Beschreibung des Ausführungsbeispiels

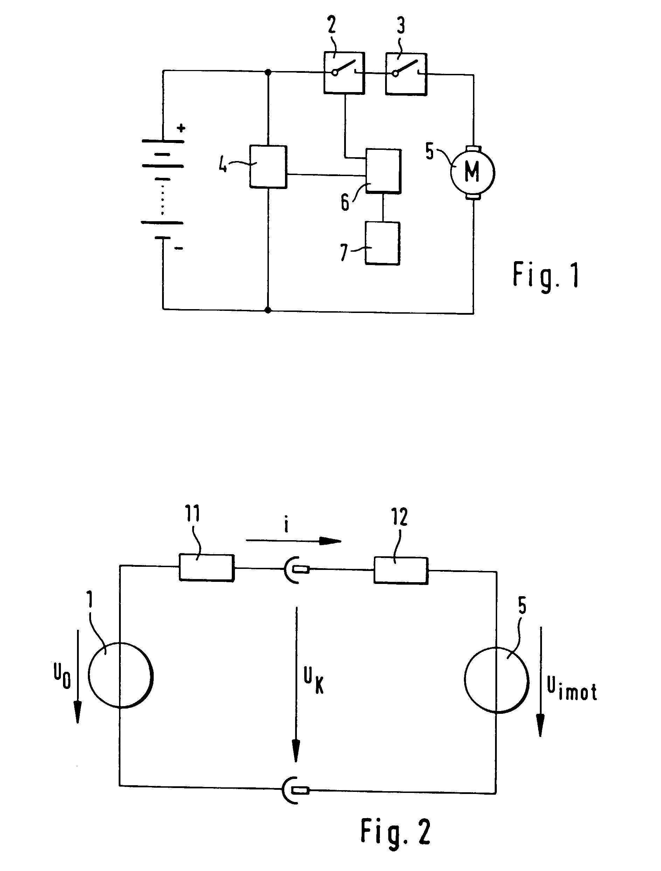

Figur 1 zeigt ein Blockschaltbild mit einer wiederaufladbaren Batterie (Akku) 1, die über einen Schalter 3 und einen weiteren Schalter 2 mit einem Motor 5 eines Akku-Werkzeuges, vorzugsweise eines Akku-Schraubers, verbunden ist. Der Schalter 3 ist beispielsweise als Transistorschalter und der weitere Schalter 2 ist als Hauptschalter ausgebildet. Diese Anordnung ist vorgesehen für Elektromotoren, insbesondere für Motoren mit Schraubvorrichtungen (Akku-Schrauber). Alternativ ist vorgesehen, die Schalter 3 als Relais vorzusehen. Parallel zur Batterie 1 ist eine Meßeinrichtung 4, vorzugsweise für Spannungsmessungen, geschaltet, deren Ausgang mit einer Auswertevorrichtung 6 verbunden ist. Ein Ausgang der Auswertevorrichtung 6 ist mit dem Steuereingang des Schalters 3 verbunden. Desweiteren ist ein Ausgang mit einer Anzeige 7 verbunden.

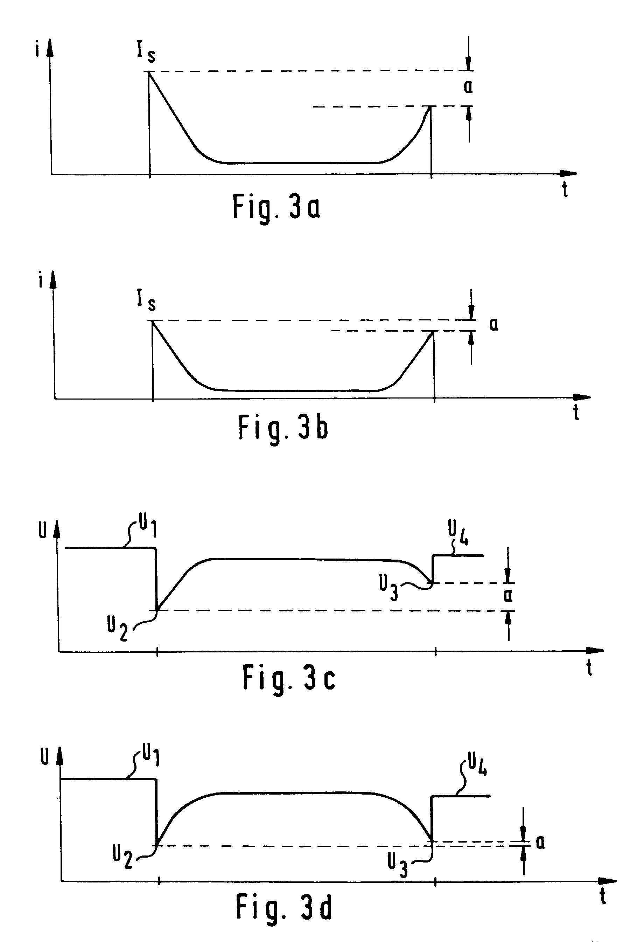

Die Funktionsweise dieser Anordnung wird anhand der Figuren 2 und 3 näher erläutert. Figur 2 das Ersatzschaltbild mit der Spannungsquelle 1 und dem Batterieinnenwiderstand 11, der zum Innenwiderstand 12 des Motors 5 in Reihe geschaltet ist. Die Erfindung beruht darauf, die Drehzahl des Motors beim Verrichten des Arbeitsvorganges, beispielsweise eines Schraubvorganges zu überwachen. Aus der Drehzahl, die durch die induzierte Ankerspannung $U_{imot}$ bestimmt wird, kann direkt oder indirekt geschlossen werden, ob der nächste Schraubvorgang noch durchgeführt werden kann oder ob der Stromfluß zum Elektromotor 5 unterbrochen werden muß. Wie aus Figur 2 ersichtlich ist, kann jederzeit die Klemmenspannung $U_K$ gemessen werden. Ist der Strom Null, dann entspricht die Klemmenspannung $U_K$ der Ersatzspannung des Akkus $U_0$ bzw. der induzierten Ankerspannung des Motors $U_{imot}$. Die Klemmenspannung $U_K$ ändert sich dabei je nach Belastung des Motors in Abhängigkeit vom Stromfluß über die Widerstände 11, 12.

Die Diagramme der Figuren 3a, 3b zeigen den Stromverlauf während eines Schraubvorganges und die Figuren 3c, 3d zeigen den entsprechenden Spannungsverlauf. Der Unterschied a zwischen dem Strom beim Einschalten und Beenden des Schraubvorganges gemäß den Figuren 3a und 3b bzw. der Spannungsunterschied a = $U_3$ - $U_2$ gemäß den Figuren 3c und 3d ist ein Maß für die Restkapazität der wiederaufladbaren Batterie. Derartige Kurven sind beispielsweise bei Nickelcadmium (NiCd) oder Nickelhydrid-Akkus (NiH) bekannt. Ein großer Abstand a (Figur 3a, 3c) zeigt daher eine große Restkapazität des Akkus, während einer kleiner Abstand a (Figur 3b, 3d), bezogen auf den Arbeitsfall, eine kleine Restkapazität bedeuten.

Dieses prinzipiell bekannte Verhalten eines Akkus wird genutzt, um einen Indikator für die Restkapazität bzw. den Ladezustand des Akkus zu finden.

Für die Ladezustandsüberwachung der wiederaufladbaren Batterie wird als Indikator die induzierte Ankerspannung $U_{imot}$ des Motors 5 verwendet. Da die induzierte Ankerspannung $U_{imot}$ nicht direkt gemessen werden kann, wird sie gemäß dem erfindungsgemäßen Verfahren nachfolgend beschrieben. Zunächst wird beim Starten des Elektromotors (Akku-Schrauber) 5 die unbelastete Batteriespannung $U_1$ mittels der Meßeinrichtung 4 gemessen, wenn der Schalter 2 geschlossen und bevor der Schalter 3 eingeschaltet ist, so daß noch kein Strom in den Motor 5 fließen kann. Anschließend wird der Motor mittels des Schalters 3 an die Batterie 1 (Akku) geschaltet. Als Schalter 3 kann ein Relais oder ein Halbleiter verwendet werden. Nach dem die Schalter 2, 3 eingeschaltet sind, fließt ein Startstrom I = $I_S$ (Figur 3a, 3b). Parallel dazu bricht die Akkuspannung auf den Wert $U_2$ (Figur 3c, 3d) ein. Dieser minimale Spannungswert stellt sich ein, wenn der Anker des Motors 5 im Stillstand ist, d.h. wenn die induzierte Spannung $U_{imot}$ Null ist. Wird das Ersatzschaltbild der Figur 2 zugrundegelegt, dann kann über das Widerstandsverhältnis das Verhältnis der beiden Spannungen bestimmt werden:

$$\frac{R_{12}}{R_{11} + R_{12}} = \frac{U_2}{U_1} \qquad\qquad \text{(Gleichung 1)}$$

Mit Hilfe dieser Gleichung kann zu jedem späteren Zeitpunkt festgestellt werden, ob sich der Motor noch dreht oder ob er steht. Für die Klemmenspannung $U_K$ (Figur 2) gilt für einen beliebigen Zeitpunkt x:

$$U_{Kx} = \frac{R_{12}}{R_{11}+R_{12}} * U_0 + (1 - \frac{R_{12}}{R_{11}+R_{12}}) * U_{imot} \qquad\qquad \text{(Gleichung 2),}$$

wobei $U_0$ die Ersatzspannung der Batterie 1 ist.

Durch Einsetzen der Gleichung 1 in Gleichung 2 und Auflösen der Gleichung 2 erhält man für die induzierte Ankerspannung des Motors:

$$U_{imot} = \frac{U_{Kx} - U_2/U_1 * U_0}{1 - U_2/U_1} \qquad\qquad \text{(Gleichung 3)}$$

$U_0$ ist die Ersatzspannung des Akkus gemäß der Figur 2. Diese Spannung entspricht der Spannung $U_1$, die vor dem Einschalten des Motors 5 gemessen wurde, wenn sie keiner zeitlichen Änderung unterliegt. Die Spannung $U_{Kx}$ entspricht der Klemmenspannung zu jedem beliebigen Zeitpunkt auf der Zeitachse t gemäß den Figuren 3a bis 3d. Somit kann zu jedem Zeitpunkt t = $t_x$ eine Spannung $U_{Kx}$ gemessen werden und daraus nach der Gleichung 3 die induzierte Ankerspannung $U_{imot}$ berechnet werden. Da die induzierte Ankerspannung $U_{imot}$ proportional zur Drehzahl des Ankers des Motors 5 ist, ergibt sich somit auch ein Wert für die Drehzahl des Motors zum Zeitpunkt t = $t_x$.

Wird die Spannung $U_{Kx}$ zu dem Zeitpunkt gemessen, wenn der Motor, beispielsweise eines Schraubwerkzeugs sein maximales Moment abgibt, dann entspricht dieses der Spannung $U_3$.

Zur Berechnung der induzierten Ankerspannung $U_{imot}$ ist noch die Kenntnis der Ersatzspannung des Akkus $U_0$ erforderlich. Kann jedoch davon ausgegangen werden, daß die Ersatzspannung des Akkus $U_0$ sich während des

Arbeitsgangs nicht wesentlich ändert und daher der Spannung $U_1$ entspricht (Figur 3c, 3d), kann zu jedem Zeitpunkt die Spannung $U_{imot}$ ermittelt werden und somit bestimmt werden, ob der Motor sich dreht. Dreht der Motor sich nicht mehr, d.h. die induzierte Spannung $U_{imot}$ ist gleich oder kleiner 0 Volt, dann kann diese Spannung für den Blockierfall ausgewertet werden und gegebenenfalls durch eine Anzeige dem Bediener optisch sichtbar gemacht werden. Das Abschalten des Stromflusses zum Motor 5 kann dabei bei Unterschreiten eines vorgegebenen Grenzwertes a zeitlich sofort oder verzögert erfolgen. Auch kann der Abschaltvorgang erst ausgelöst werden, wenn beispielsweise im Blockierfall der Anker eine gewisse Zeit steht. Dadurch werden vorteilhaft kurzzeitige Störungen unterdrückt.

Der Bediener erhält somit ein optisches oder auch akustisches Signal, wenn der Anker blockiert ist. Dieses Signal kann auch dazu verwendet werden, den Motor nach einer vorgegebenen Zeit, beispielsweise nach einigen hundert Millisekunden stromlos zu schalten, um einerseits den Motor zu schützen und andererseits die Batterie nicht unnötig zu entladen.

$$U_0 = U_1 \qquad \text{(Gleichung 4)}$$

Wird nun $U_0 = U_1$ in Gleichung 3 eingesetzt, dann vereinfacht sich die Rechnung für die induzierte Ankerspannung $U_{imot}$

$$U_{imot} \sim U_{Kx} - U_2 \qquad \text{(Gleichung 5)}$$

Je nachdem wie groß diese Spannungsdifferenz a für die induzierte Ankerspannung $U_{imot}$ ist, läßt sich daraus auf die Restkapazität der Batterie 1 gemäß den Figuren 3c, 3d schließen. Eine große Differenz a bedeutet eine große Restkapazität und eine kleine Differenz a bedeutet eine kleine Restkapaztität der Batterie 1.

Die Ersatzspannung $U_0$ kann jedoch auch dadurch ermittelt werden, daß die Batteriespannung einige Millisekunden nach Beendigung des Schraubvorganges und nach dem Abschalten des Motors 5 gemessen wird. In diesem Fall entspricht die Spannung $U_0 = U_4$.

## Patentansprüche

1. Verfahren zur Überwachung des Ladezustands einer wiederaufladbaren Batterie (1), die über einen schalter (2,3) mit einem Motor (5) eines Akku-Handwerkzeuges, vorzugsweise eines Akku-Schraubers verbunden ist, wobei eine Meßeinrichtung (4) vorzugsweise die Batteriespannung erfaßt, mit den weiteren Merkmalen,

   a) daß bei Durchführung des Arbeitsvorgangs die Meßeinrichtung (4) vor dem Betätigen des Schalters (3) eine erste Messung ($U_1$) der Batteriespannung durchführt,

   b) daß die Meßeinrichtung (4) unmittelbar nach dem Betätigen des Schalters (3) etwa bei Stillstand des Ankers des Motors (5) eine zweite Messung ($U_2$) durchführt,

   c) daß die Meßeinrichtung (4) während des Arbeitsvorgangs für eine zu berechnende Drehzahl eine dritte Spannungsmessung ($U_3$) durchführt,

   d) daß eine Auswertevorrichtung (6) aus den gemessenen Spannungen (U1 bis U3) nach einem vorgegebenen Algorithmus eine der Drehzahl proportionale Spannung ($U_{imot}$) berechnet,

   e) und daß abhängig von der berechneten Spannung ($U_{imot}$) der Schalter (3) für einen weiteren Arbeitsvorgang freigegeben wird.

2. Verfahren nach Anspruch 1, dadurch gekennzeichnet, daß die Auswertevorrichtung (6) die induzierte Spannung ($U_{imot}$) nach der Formel

$$U_{imot} \sim U_3 - U_2$$

bestimmt.

**3.** Verfahren nach Anspruch 1, dadurch gekennzeichnet, daß die Meßeinrichtung (4) nach dem Abschalten des Motors (5) eine vierte Messung ($U_4$) durchführt.

**4.** Verfahren nach Anspruch 3, dadurch gekennzeichnet, daß die Auswertevorrichtung (6) die induzierte Spannung ($U_{imot}$) nach der Formel

$$U_{imot} = \frac{U_3 - \dfrac{U_2 * U_4}{U_1}}{1 - \dfrac{U_2}{U_1}}$$

bestimmt.

**5.** Verfahren nach einem der vorhergehenden Ansprüche, dadurch gekennzeichnet, daß die Meßeinrichtung (4) die dritte Spannung ($U_3$) bei Abgabe des während des Arbeitsganges auftretenden maximalen Drehmomentes des Motors (5) ermittelt.

**6.** Verfahren nach einem der vorhergehenden Ansprüche, dadurch gekennzeichnet, daß die Auswertevorrichtung (6) bei Unterschreiten eines Grenzwertes (a) für die induzierte Spannung ($U_{imot}$) den Stromfluß zum Motor (5) mittels des Schalters (3) nach einer vorgegebenen Zeitspanne sperrt.

**7.** Verfahren nach Anspruch 6, dadurch gekennzeichnet, daß die Auswertevorrichtung (6) bei Unterschreiten des Grenzwertes (a) den Stromfluß zum Motor (5) sofort sperrt.

**8.** Verfahren nach Anspruch 6 oder 7, dadurch gekennzeichnet, daß die Auswertevorrichtung (6) bei anhaltender Unterschreitung des Grenzwertes (a) den Stromfluß für einen nächsten Arbeitsgang dauerhaft sperrt.

**9.** Verfahren nach einem der vorhergehenden Ansprüche, dadurch gekennzeichnet, daß die Freigabe oder Sperrung des Stromflusses auf einer Anzeige akustisch oder optisch ausgegeben wird.

**Claims**

**1.** Method for monitoring the charge state of a rechargeable battery (1) which is connected via a switch (2, 3) to a motor (5) of a battery-powered handtool, preferably a battery-powered screwdriver, a measuring device (4) preferably detecting the battery voltage, having the further features

a) that, when the operating process is being carried out, the measuring device (4) carries out a first measurement ($U_1$) of the battery voltage before the operation of the switch (3),

b) that the measuring device (4) carries out a second measurement ($U_2$) immediately after operation of the switch (3) roughly when the armature of the motor (5) stops,

c) that the measuring device (4) carries out a third voltage measurement ($U_3$), for a rotation speed to be calculated, during the operating process,

d) that an evaluation apparatus (6) uses the measured voltages ($U_1$ to $U_3$) to calculate a voltage ($U_{imot}$) proportional to the rotation speed, using a predetermined algorithm,

e) and in that, depending on the calculated voltage ($U_{imot}$), the switch (3) is released for a further operating process.

**2.** Method according to Claim 1, characterized in that the evaluation apparatus (6) determines the induced voltage ($U_{imot}$) using the formula

$$U_{imot} \sim U_3 - U_2.$$

**3.** Method according to Claim 1, characterized in that the measuring device (4) carries out a fourth measurement ($U_4$) after the motor (5) has been switched off.

**4.** Method according to Claim 3, characterized in that the evaluation apparatus (6) determines the induced voltage ($U_{imot}$) using the formula

$$U_{imot} = \frac{U_3 - \dfrac{U_2 * U_4}{U_1}}{1 - \dfrac{U_2}{U_1}}$$

**5.** Method according to one of the preceding claims, characterized in that the measuring device (4) determines the third voltage ($U_3$) when the maximum torque which occurs during the operating process is being emitted by the motor (5).

**6.** Method according to one of the preceding claims, characterized in that, if the induced voltage ($U_{imot}$) is less than a limit value (a), the evaluation apparatus (6) inhibits the current flow to the motor (5), by means of the switch (3), after a predetermined time interval.

**7.** Method according to Claim 6, characterized in that, if the limit (a) is undershot, the evaluation apparatus (6) inhibits the current flow to the motor (5) immediately.

**8.** Method according to Claim 6 or 7, characterized in that, if the limit (a) continues to be undershot, the evaluation apparatus (6) permanently inhibits the current flow for a next operating process.

**9.** Method according to one of the preceding claims, characterized in that the enabling or inhibiting of the current flow is output audibly or visually on an indicator.

## Revendications

**1.** Procédé de contrôle de l'état de charge d'une batterie rechargeable (1) reliée par un interrupteur (2, 3) à un moteur (5) d'un outil à main, alimenté par une batterie, de préférence une visseuse à batterie, selon lequel une installation de mesure (4) détecte de préférence la tension de batterie, et ayant les caractéristiques suivantes :

a) lors de l'exécution du travail, l'installation de mesure (4) effectue avant l'actionnement de l'interrupteur (3), une première mesure ($U_1$) de la tension de batterie,
b) l'installation de mesure (4) effectue une seconde mesure ($U_2$) directement après l'actionnement de l'interrupteur (3), sensiblement à l'arrêt de l'induit du moteur (5),
c) l'installation de mesure (4) effectue une troisième mesure de tension ($U_3$) pendant l'opération de l'outil, pour une vitesse de rotation à calculer,
d) un circuit d'exploitation (6) calcule à partir des tensions mesurées ($U_1$ - $U_3$) et selon un algorithme prédéterminé, une tension ($U_{imot}$) proportionnelle à la vitesse de rotation,
e) et en fonction de la tension calculée ($U_{imot}$) l'interrupteur (3) est libéré pour une nouvelle opération.

**2.** Procédé selon la revendication 1,
caractérisé en ce que
le dispositif d'exploitation (6) détermine la tension induite ($U_{imot}$) selon la formule ($U_{imot}$) à peu près égale à ($U_3$ - $U_2$).

**3.** Procédé selon la revendication 1,
caractérisé en ce que
l'installation de mesure (4) effectue une quatrième mesure ($U_4$) après l'arrêt du moteur (5).

**4.** Procédé selon la revendication 3,
caractérisé en ce que
le dispositif d'exploitation (6) calcule la tension induite ($U_{imot}$) selon la formule suivante :

$$U_{imot} = \frac{U_3 - \dfrac{U_2 \cdot U_4}{U_1}}{1 - \dfrac{U_2}{U_1}}$$

**5.** Procédé selon l'une quelconque des revendications précédentes,
caractérisé en ce que
l'installation de mesure (4) détermine la troisième tension ($U_3$) à l'émission du couple maximum se produisant pendant une opération par le moteur (5).

**6.** Procédé selon l'une quelconque des revendications précédentes,
caractérisé en ce que
le dispositif d'exploitation (6) lorsqu'on dépasse vers le bas un seuil (a) pour la tension induite ($U_{imot}$) bloque le passage du courant vers le moteur (5) à l'aide de l'interrupteur (3) et cela pendant une durée prédéterminée.

**7.** Procédé selon la revendication 6,
caractérisé en ce que
le dispositif d'exploitation (6) bloque immédiatement l'alimentation électrique du moteur (5) en cas de dépassement vers le bas de la valeur limite (a).

**8.** Procédé selon l'une quelconque des revendications 6 ou 7,
caractérisé en ce que
le dispositif d'exploitation (6) bloque en permanence le passage du courant pour l'opération suivante en cas de dépassement persistant de la valeur limite (a).

**9.** Procédé selon l'une quelconque des revendications précédentes,
caractérisé en ce que
la libération de blocage du passage du courant est affichée de manière optique ou acoustique sur un moyen d'affichage.

Fig. 1

Fig. 2

Fig. 3a

Fig. 3b

Fig. 3c

Fig. 3d